# EUROPEAN PATENT SPECIFICATION

(11) **EP 0 463 885 B1**
(45) Date of publication and mention of the grant of the patent: **27.08.1997**
(21) Application number: 91305904.4
(22) Date of filing: 28.06.1991
(51) Int. Cl.: H04N 5/92, G11B 20/02

(54) **Non-linear de-emphasis circuits**
Nichtlineare Deemphasisschaltung
Circuit de déaccentuation non linéaire

(30) Priority: 29.06.1990 JP 173725/90
(43) Date of publication of application: 02.01.1992
(73) Proprietor: SONY CORPORATION, Tokyo 141 (JP)
(72) Inventor: Urata, Kaoru, c/o Patents Division, Shinagawa-ku, Tokyo 141 (JP)
(74) Representative: Pilch, Adam John Michael

(56) References cited:
- EP-A- 0 354 734
- US-A- 4 864 404
- PATENT ABSTRACTS OF JAPAN vol. 11, no. 343 (E-555)10 November 1987 & JP-A-62 123 881

## Description

This invention relates to non-linear de-emphasis circuits which may, for example, be used in video tape recorders.

Video tape recorders are generally designed such that a nonlinear emphasis circuit and a non-linear de-emphasis circuit are included in order to ensure that the reproduced signal has a high signal-to-noise (SN) ratio.

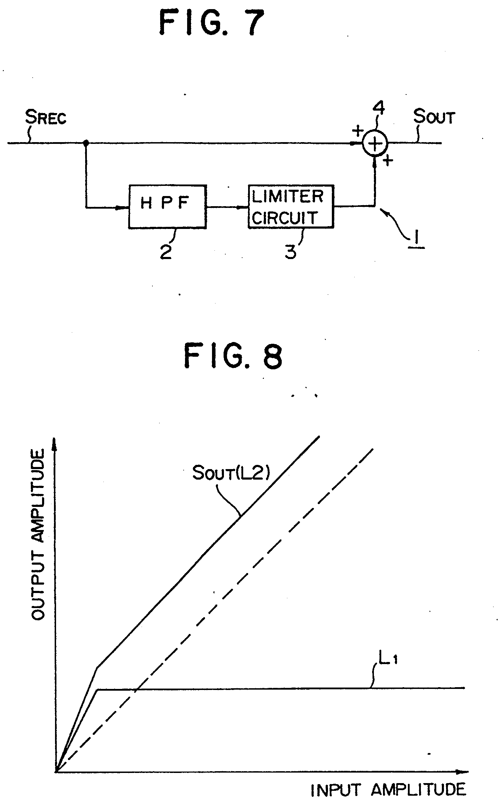

One example of a previously-proposed non-linear emphasis circuit is shown in Figure 7 of the accompanying drawings. Referring to Figure 7, the non-linear emphasis circuit 1 is arranged such that high frequency components of a recording signal S_{REC} are extracted by a high-pass filter circuit (HPF) 2, and then the filtered recording signal S_{REC} is supplied to an adding circuit 4 by way of a limiter circuit 3.

Consequently, high frequency components of the recording signal S_{REC} are amplitude limited by the limiter circuit 3 as seen from a curve L1 shown in Figure 8.

The output signal from the limiter circuit 3 is added to the original recording signal S_{REC} by the adding circuit 4 to produce an output signal S_{OUT} to be recorded on to a magnetic tape. Consequently, the recording signal S_{REC} is recorded with the high frequency components of low amplitude emphasised as seen from another curve L2 shown in Figure 8.

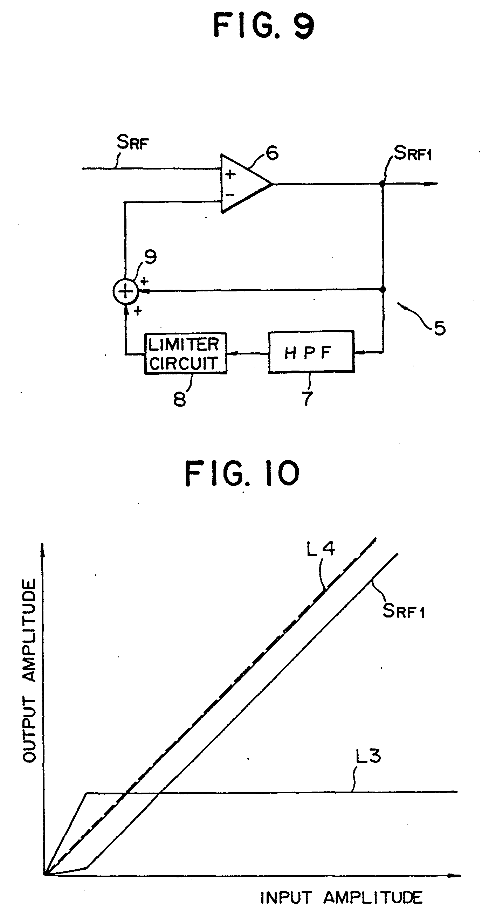

An example of a previously-proposed non-linear de-emphasis circuit is shown in Figure 9. Referring to Figure 9, the non-linear de-emphasis circuit 5 is arranged such that a reproduction signal S_{RF} reproduced from the magnetic tape is applied to a differential amplifier circuit 6, and a feedback loop to the differential amplifier circuit 6 is formed by a high-pass filter circuit (HPF) 7, a limiter circuit 8 and an adding circuit 9.

In this instance, the characteristics of the high-pass filter circuit 7, the limiter circuit 8 and the adding circuit 9 are set to the same characteristics (shown by a curve L3 in Figure 10) as those of the high-pass filter circuit 2, the limiter circuit 3 and the adding circuit 4 of the non-linear emphasis circuit 1, so that the reproduction signal S_{RF} may be corrected with an inverse characteristic to that of the non-linear emphasis circuit 1 (the output signal from the non-linear de-emphasis circuit 5 is illustrated by a curve S_{RF1} in Figure 10).

Consequently, the transfer function of the recording and reproducing system is set to unity to suppress noise components of low amplitude at high frequency.

Another example of a previously-proposed non-linear de-emphasis circuit is disclosed in Japanese Patent Laid-Open Application JP-A-62123881 and is shown in Figure 11. Referring to Figure 11, the non-linear de-emphasis circuit 10 includes a limiter circuit 12 to effect amplitude limiting separately in order to raise the effect of improvement in SN ratio.

In particular, a reproduction signal S_{RF} is received at a subtracting circuit 13, and the output signal of the subtracting circuit 13 is supplied via a high-pass filter circuit (HPF) 7 and a limiter circuit 8 back to the subtracting input of the subtracting circuit 13.

Thus, at the subtracting circuit 13, the output signal of the limiter circuit 8 is subtracted from the reproduction signal S_{RF}. Accordingly, a similar characteristic to that of the non-linear de-emphasis circuit 5 (wherein a feedback loop to the differential amplifier circuit 6 is formed as described hereinabove with reference to Figure 9) is obtained.

When the output signal of the limiter circuit 8 is to be subtracted from the reproduction signal S_{RF}, such subtraction is performed, in the non-linear de-emphasis circuit 10, by a subtracting circuit 16 such that the output signal of the limiter circuit 8 is transmitted to the subtracting circuit 16 by way of the limiter circuit 12 and an attenuator 14.

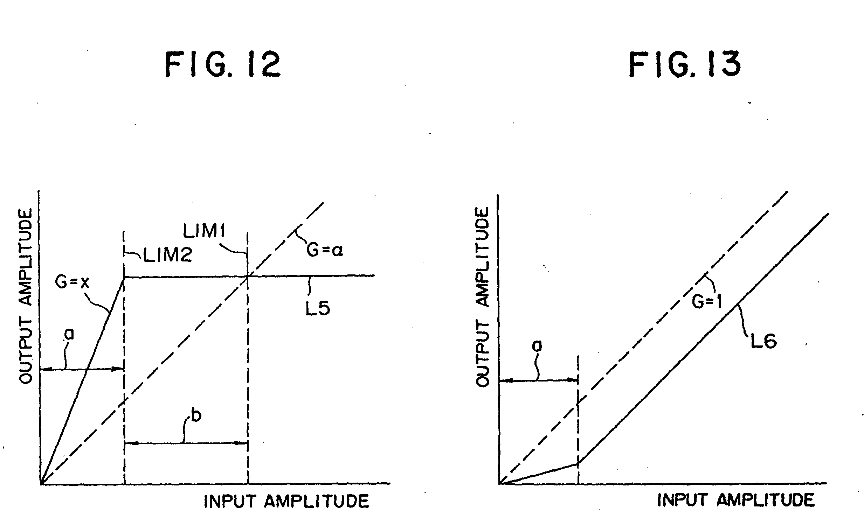

As seen from Figure 12, the limiter circuit 12 amplitude limits an input signal when said input signal exceeds an amplitude limiting value LIM2 which is lower than amplitude limiting value LIM1 of the limiter circuit 8. In each case, the amplitude limiting value is the input value of the respective limiter circuit above which no change in output value occurs.

In this instance, the gain x of the limiter circuit 12 and the attenuator 14, when the amplitude of the output signal of the limiter circuit 8 is low, is maintained such that it may satisfy the following expression:$\text{α < x ≤} \frac{\text{1 + A α}}{\text{A}}$ where A is the gain of the high-pass filter circuit 7 and the limiter circuit 8 at a low amplitude and high frequency, and α is the gain of an attenuator 18 interposed between the output of the limiter circuit 8 and the subtracting input of the subtracting circuit 13. Thus, the input/output characteristic of the limiter circuit 12 and the attenuator 14 is set as shown by a curve L5 in Figure 12.

Consequently, an input/output characteristic is obtained wherein high frequency low amplitudes are suppressed, compared with the non-linear de-emphasis circuit 5, by an amount of a region a over which the limiter circuit 12 does not limit the amplitude, as seen in Figure 13.

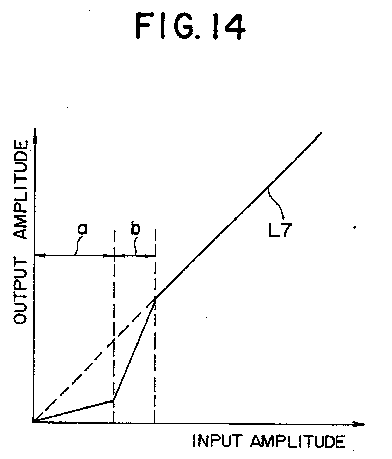

Accordingly, high frequency low amplitudes are suppressed by the entire recording and reproducing system, as shown by a curve L7 in Figure 14, and the SN ratio can be improved over that of the non-linear de-emphasis circuit 5.

However, while the effect of improvement in SN ratio of the non-linear de-emphasis circuit 10 is high, since high frequency low amplitudes are suppressed in the region a, original signal components included in the region a are also suppressed, and as a result, delicate contours of a reproduced picture image will be degraded.

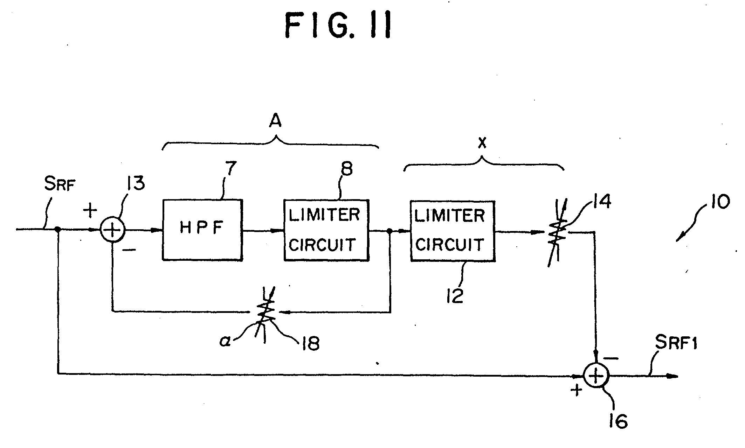

US Patent US-A-4 864 404 discloses a noise reduction circuit similar to that described above with reference to Figure 11. Two limiter circuits are provided, one in a feedback loop as in Figure 9, and multiplier circuits modify the respective amplitude levels of the signals from the limiter circuits.

According to the invention there is provided a non-linear de-emphasis circuit comprising:
a first subtracting circuit for subtracting an amplitude limited signal from an input signal;
a high-pass filter circuit for extracting high frequency components from the output signal from said first subtracting circuit;
a first limiter circuit for amplitude limiting the output signal from said high-pass filter circuit when an input value of the first limiter circuit exceeds an amplitude limiting value, thereby to produce said amplitude limited signal for supply to said first subtracting circuit;
a non-linear amplifier circuit for amplifying, when the amplitude limited signal has an amplitude within a low amplitude value range which is set to be lower than the amplitude limiting value of said first limiter circuit, the amplitude limited signal with a non-zero gain greater than a predetermined value; and
a second subtracting circuit for subtracting the output signal from said non-linear amplifier circuit from the input signal to produce an output signal from said non-linear de-emphasis circuit;
said non-linear amplifier circuit being further operable in response to an increase in amplitude of the amplitude limited signal beyond said low amplitude value range to alter the input/output characteristic such that said non-linear amplifier circuit amplifies the amplitude limited signal with a gain equal to said predetermined non-zero value.

In non-linear de-emphasis circuits embodying the invention, high frequency components can be suppressed in a region in which the amplitude is low, and the circuits have an improved SN ratio and a simple construction without causing deterioration in a delicate waveform of the reproduced signal.

The invention will now be described by way of example with reference to the accompanying drawings, throughout which like parts are referred to by like references, and in which:
Figure 1 is a block diagram of a non-linear de-emphasis circuit according to a preferred embodiment of the invention;
Figures 2 to 4 are diagrams illustrating the operation of the non-linear de-emphasis circuit of Figure 1;
Figure 5 is a circuit diagram of a non-linear amplifier circuit according to a second preferred embodiment of the invention;
Figure 6 is a diagram illustrating the operation of the non-linear amplifier circuit of Figure 5;
Figure 7 is a block diagram showing a non-linear emphasis circuit;
Figure 8 is a diagram illustrating the operation of the non-linear emphasis circuit of Figure 7;
Figure 9 is a block diagram showing a previously-proposed non-linear de-emphasis circuit;
Figure 10 is a diagram illustrating the operation of the non-linear de-emphasis circuit of Figure 9;
Figure 11 is a block diagram showing another previously-proposed non-linear de-emphasis circuit having an improved SN ratio; and
Figures 12 to 14 are diagrams illustrating the operation of the non-linear de-emphasis circuit of Figure 11.

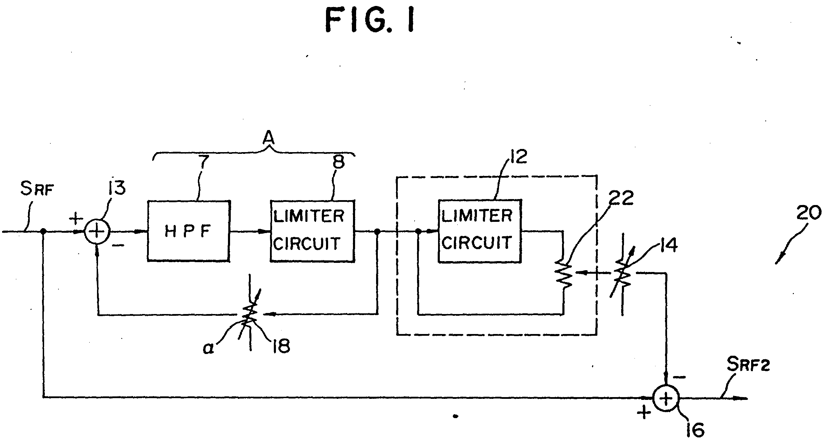

Referring first to Figure 1, there is shown a non-linear de-emphasis circuit 20 embodying the present invention. The non-linear de-emphasis circuit 20 has similarities in construction to the previously-proposed non-linear de-emphasis circuit 10 described hereinabove with reference to Figure 11. Accordingly, only the components not present in the circuit 10 of Figure 11 will be described in detail. The non-linear de-emphasis circuit 20 additionally includes a mixer 22 interposed between the limiter circuit 12 and the attenuator 14 such that input and output signals of the limiter circuit 12 are mixed at a desired ratio, and the resulting mixed signal is supplied to the attenuator 14.

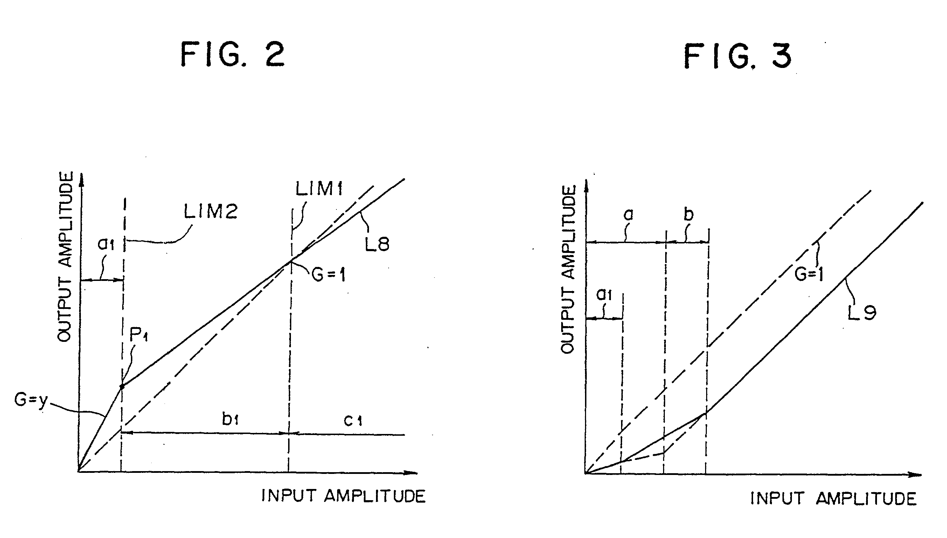

Accordingly, the output signal of the attenuator 14 rises, as seen from a curve L8 in Figure 2, with a gain G (= y) with respect to the input signal given by the following expression:$\text{1 < y ≤} \frac{\text{1 + Aα}}{\text{Aα}}$ and then the gain drops from a point P1 determined with a limiting ratio of the mixer 22 lower than an amplitude limiting value LIM2 of the limiter circuit 12, and intersects with a straight line (indicated by a broken line) of a gain equal to unity at an amplitude limiting value LIM1 of the limiter circuit 8. In each case, the amplitude limiting value is the input value of the respective limiter circuit above which no change in output value occurs.

Consequently, as seen from a curve L9 in Figure 3 (in which a previously-proposed input/output characteristic is indicated by a broken line), a region a₁ within which the gain rises with the value G (= y) can be made smaller than an alternative region a within which the gain rises similarly with the value G (= x) in the previously-proposed non-linear de-emphasis circuit 10 shown in Figure 11.

Accordingly, the SN ratio can be improved, without damaging a delicate contour of a reproduced picture image, by an amount over which the region a₁ within which the gain rises with the value G =( y) is reduced, with a simple construction, namely the mixer 22 being interposed between the limiter circuit 12 and the attenuator 14.

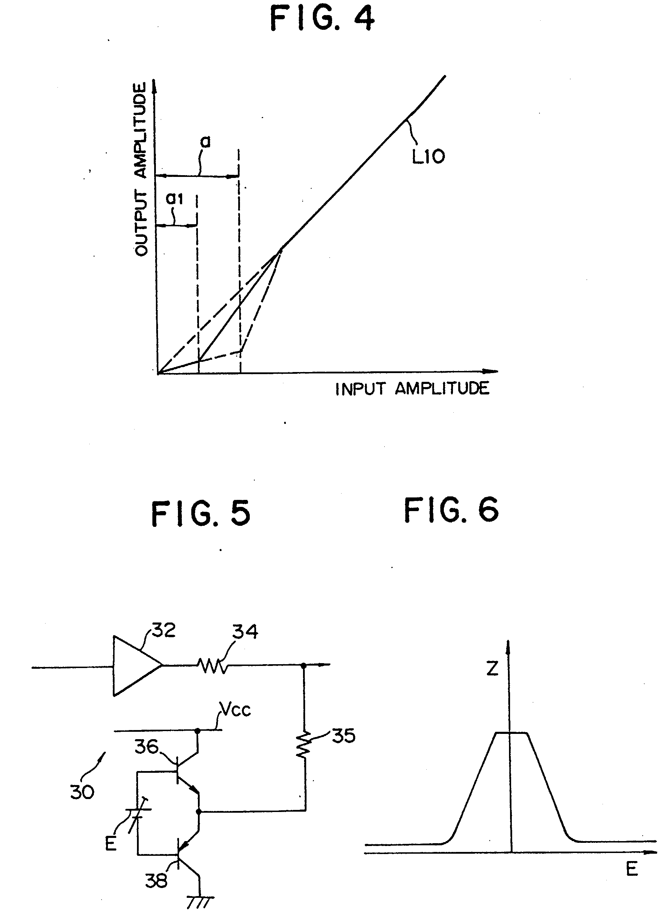

In particular, as seen from a curve L10 in Figure 4 which shows a general input/output characteristic of the non-linear de-emphasis circuit 20, the region in which high frequency low amplitudes are suppressed is decreased within a sufficient range for practical use compared with the previously-proposed non-linear de-emphasis circuit, and the SN ratio can be improved without damaging a delicate contour of a reproduced picture image.

Further, when a variable mixer is used as the mixer 22 thereby allowing the mixing ratio to be changed, the characteristic of the nonlinear de-emphasis circuit 20 can be chosen freely from between the characteristic of the non-linear de-emphasis circuit 5 described hereinabove with reference to Figure 9 and the characteristic of the non-linear de-emphasis circuit 10 described hereinabove with reference to Figure 11; a wide range of desired noise reducing effects can thus be provided.

In the present embodiment, the subtracting circuit 13 constitutes a subtracting circuit for subtracting an amplitude limited signal from an input signal S_{RF}, and the high-pass filter circuit 7 constitutes a high-pass filter circuit for extracting high frequency components from an output signal of the subtracting circuit 13.

While the limiter circuit 8 constitutes a limiter circuit for amplitude limiting an output signal of the high-pass filter circuit 7 to produce the amplitude limited signal, the limiter circuit 12 and the mixer 22 constitute a non-linear amplifier circuit which amplifies, at a lower amplitude (a₁) than the amplitude limiting value LIM2 of the limiter circuit 12, the amplitude limited signal with a gain higher than unity, but which changes over, in response to an increase in amplitude, the input/output characteristic thereof such that, when the amplitude is above the lower amplitude range a₁. the gain is reduced as shown in Figure 2; the subtracting circuit 16 constitutes a subtracting circuit for subtracting an output signal of the non-linear amplifier circuit from the input signal S_{RF}.

With the non-linear de-emphasis circuit 20 as described above, a reproduction signal S_{RF} is supplied by way of the subtracting circuit 13 to the high-pass filter 7, at which high frequency components are extracted from the reproduction signal S_{RF}, whereafter the filtered reproduction signal is amplitude limited by the limiter circuit 8.

Consequently, an inverse characteristic to that of a non-linear emphasis circuit can be obtained by subtracting the output signal from the limiter circuit 8 from the original reproduction signal S_{RF}.

In particular, the output signal from the limiter circuit 8 is fed back to the subtracting circuit 13 by way of the attenuator 18, and is also supplied to the non-linear amplifier circuit.

In the non-linear amplifier circuit, the output signal from the limiter circuit 8 is amplitude limited by the limiter circuit 12, and the amplitude limited signal is mixed with the output signal from the limiter circuit 8 by means of the mixer 22; the output signal from the mixer 22 is then supplied to the subtracting circuit 16 by way of the attenuator 14.

At the subtracting circuit 16, the output signal from the limiter circuit 8 is subtracted from the original reproduction signal S_{RF}. Consequently, an inverse characteristic to that of the non-linear emphasis circuit is obtained.

In this instance, since the output signal from the limiter circuit 8 is further amplitude limited by the limiter circuit 12, mixed by the mixer 22 and then subtracted from the original reproduction signal S_{RF}, high frequency components can be suppressed in the region a₁ in which the amplitude is sufficiently lower than the amplitude limiting value LIM2 of the limiter circuit 12, and the SN ratio can be improved without damaging delicate contours of a reproduced picture image.

According to the construction described thus far, when the output signal from the limiter circuit 8 is to be subtracted from the reproduction signal to obtain an inverse characteristic to that of a non-linear emphasis circuit, it is first amplitude limited by the limiter circuit 12 and mixed by the mixer 22, and then subtracted from the original reproduction signal S_{RF}. Consequently, high frequency components can be suppressed in the region a₁ in which the amplitude is lower than the amplitude limiting value LIM2 of the limiter circuit 12, and the SN ratio can be improved by means of a simple construction without damaging delicate contours of a reproduced picture image.

In the embodiment of Figure 1, the non-linear amplifier circuit is constituted by the limiter circuit 12 and the mixer 22. However, the characteristic shown in Figure 2 can alternatively be obtained by means of non-linear amplifier circuits of various different constructions. An example of such an alternative non-linear amplifier circuit is shown in Figure 5.

Referring to Figure 5, the non-linear amplifier circuit 30 is constituted such that the output signal from the limiter circuit 8 is applied to an amplifier circuit 32, and the output signal from the amplifier circuit 32 is supplied to the attenuator 14 by way of a resistor 34.

Further, the output end of the resistor 34 (adjacent the attenuator 14) is connected to the emitters of a pair of transistors 36 and 38 by way of a resistor 35.

The collectors of the transistors 36 and 38 are connected to a power source line Vcc and to earth, respectively, so that they may be switched to an on-state in response to a potential difference E between the bases thereof as seen in Figure 6.

Accordingly, by controlling the potential difference E between the bases of the transistors 36 and 38 in response to the output signal from the limiter circuit 8, the output signal from the limiter circuit 8 is supplied, at low amplitude, with an impedance which is set by the resistor 34, but as the amplitude increases, it is supplied at a signal level provided by voltage division by means of the resistors 34 and 35.

Accordingly, a non-linear amplifier circuit having the same characteristic as the non-linear amplifier circuit shown in Figure 1 can be obtained by selecting suitable resistance values of the resistors 34 and 35 and a suitable gain of the amplifier circuit 32.

It is to be noted that, while embodiments of the present invention have been described as applied to a video tape recorder, the invention may equally well be applied to other recording/reproduction systems. For example, the invention may be applied to a reproduction system for a video signal, or even to a reproduction system for an audio signal, thereby improving the SN ratio while minimising the distortion in the reproduced signal.

## Claims

1. A non-linear de-emphasis circuit (20) comprising:
a first subtracting circuit (13) for subtracting an amplitude limited signal from an input signal (S_{RF});
a high-pass filter circuit (7) for extracting high frequency components from the output signal from said first subtracting circuit (13);
a first limiter circuit (8) for amplitude limiting the output signal from said high-pass filter circuit (7) when an input value of the first limiter circuit (8) exceeds an amplitude limiting value (LIM1), thereby to produce said amplitude limited signal for supply to said first subtracting circuit (13);
a non-linear amplifier circuit (12, 22; 30) for amplifying, when the amplitude limited signal has an amplitude within a low amplitude value range (a₁) which is set to be lower than the amplitude limiting value (LIM1) of said first limiter circuit (8), the amplitude limited signal with a non-zero gain (G = y) greater than a predetermined value; and
a second subtracting circuit (16) for subtracting the output signal from said non-linear amplifier circuit (12, 22; 30) from the input signal (S_{RF}) to produce an output signal (S_{RF2}) from said non-linear de-emphasis circuit (20);
said non-linear amplifier circuit (12, 22; 30) being further operable in response to an increase in amplitude of the amplitude limited signal beyond said low amplitude value range (a₁) to alter the input/output characteristic such that said non-linear amplifier circuit (12, 22; 30) amplifies the amplitude limited signal with a gain equal to said predetermined non-zero value.

2. A non-linear de-emphasis circuit (20) according to claim 1, wherein said non-linear amplifier circuit includes a second limiter circuit (12) to which the amplitude limited signal is applied, the second limiter circuit (12) having an amplitude limiting value (LIM2) which is the input value of the second limiter circuit (12) above which no change in output value occurs, the amplitude limiting value (LIM2) of the second limiter circuit (12) being lower than the amplitude limiting value (LIM1) of said first limiter circuit (8), and a mixer (22) for mixing the output signal from said second limiter circuit (12) with the amplitude limited signal from the first limiter circuit (8), said non-linear amplifier circuit having a non-linear input/output amplifying characteristic which depends on the mixing ratio of said mixer (22).

3. A non-linear de-emphasis circuit according to claim 2, wherein the mixer is a variable mixer (22).

4. A non-linear de-emphasis circuit according to claim 1, wherein said non-linear amplifier circuit (30) includes an amplifier (32) to which the amplitude limited signal is supplied, a first resistor (34) connected to an output side of said amplifier (32), a second resistor (35) connected to an output side of said first resistor (34), and amplitude detecting means (E, 36, 38) connected to said second resistor (35), and wherein the amplitude limited signal is supplied via an output impedance provided by said first resistor (34) when the amplitude of the amplitude limited signal is lower than a detectable value of said amplitude detecting means (E, 36, 38), but when the amplitude of the amplitude limited signal is equal to or higher than the detectable value of said amplitude detecting means (E, 36, 38), the amplitude limited signal is supplied as a signal divided by said first and second resistors (34, 35).

5. A non-linear de-emphasis circuit (20) according to any one of the preceding claims, wherein the predetermined non-zero value of gain is unity.

## Patentansprüche

1. Nichtlineare Deemphasisschaltung (20) mit
einer ersten Subtrahierschaltung (13) zum Subtrahieren eines amplitudenbegrenzten Signals von einem Eingangssignal (S_{RF}),
einer Hochpaßfilterschaltung (7) zum Extrahieren von hochfrequenten Komponenten aus dem Ausgangssignal der ersten Subtrahierschaltung (13),
einer ersten Begrenzerschaltung (8) zur Amplitudenbegrenzung des Ausgangssignals der Hochpaßfilterschaltung (7), wenn der Eingangswert der ersten Begrenzerschaltung (8) einen Amplitudenbegrenzungswert (LIM1) überschreitet, um dadurch das der ersten Subtrahierschaltung (13) zuzuführende amplitudenbegrenzte Signal zu erzeugen,
einer nichtlinearen Verstärkerschaltung (12, 22; 30) zum Verstärken des amplitudenbegrenzten Signals mit einem von Null verschiedenen Verstärkungsfaktor (G = y), der größer ist als ein vorbestimmter Wert, wenn die Amplitude des amplitudenbegrenzten Signals innerhalb eines niedrigen Amplitudenwertbereichs (a₁) liegt, der niedriger eingestellt ist als der Amplitudenbegrenzungswert (LIM1), und
einer zweiten Subtrahierschaltung (16) zum Subtrahieren des Ausgangssignals der nichtlinearen Verstärkerschaltung (12, 22; 30) von dem Eingangssignal (S_{RF}), um das Ausgangssignal (S_{RF2}) der nichtlinearen Deemphasisschaltung (20) zu erzeugen,
wobei die nichtlineare Verstärkerschaltung (12, 22; 30) ferner in Abhängigkeit von einer Amplitudenvergrößerung des amplitudenbegrenzten Signals über den genannten niedrigen Amplitudenwertbereich (a₁) hinaus so betreibbar ist, daß sie die Eingangs-/Ausgangskennlinie so verändert, daß die nichtlineare Verstärkerschaltung (12, 22; 30) das amplitudenbegrenzte Signal mit einem Verstärkungsfaktor verstärkt, der gleich dem genannten vorbestimmten von Null verschiedenen Wert ist.

2. Nichtlineare Deemphasisschaltung (20) nach Anspruch 1, bei der die nichtlineare Verstärkerschaltung aufweist:
eine zweite Begrenzerschaltung (12), der das amplitudenbegrenzte Signal zugeführt wird, wobei diese zweite Begrenzerschaltung (12) einen Amplitudenbegrenzungswert (LIM2) besitzt, der derjenige Eingangswert der zweiten Begrenzerschaltung (12) ist, oberhalb dessen keine Änderung des Ausgangssignals auftritt, wobei der Amplitudenbegrenzungswert (LIM2) der zweiten Begrenzerschaltung (12) niedriger ist als der Amplitudenbegrenzungswert (LIM1) der ersten Begrenzerschaltung (8),
sowie einen Mischer (22) zum Mischen des Ausgangssignals der zweiten Begrenzerschaltung (12) mit dem amplitudenbegrenzten Signal aus der ersten Begrenzerschaltung (8), wobei die nichtlineare Verstärkerschaltung eine nichtlineare Eingangs-/Ausgangsverstärkungskennlinie besitzt, die von dem Mischungsverhältnis des Mischers (22) abhängt.

3. Nichtlineare Deemphasisschaltung nach Anspruch 2, bei der der Mischer ein variabler Mischer (22) ist.

4. Nichtlineare Deemphasisschaltung nach Anspruch 1, bei der die nichtlineare Verstärkerschaltung (30) aufweist:
einen Verstärker (32), dem das amplitudenbegrenzte Signal zugeführt wird,
einen ersten Widerstand (34), der mit der Ausgangsseite des Verstärkers (32) verbunden ist,
einen zweiten Widerstand (35), der mit der Ausgangsseite des ersten Widerstands verbunden ist.
und eine Amplitudendetektoreinrichtung (E, 36, 38), die mit dem zweiten Widerstand (35) verbunden ist,
wobei dann, wenn die Amplitude des amplitudenbegrenzten Signals kleiner ist als ein von der Amplitudendetektoreinrichtung (E, 36, 38) detektierbarer Wert, das amplitudenbegrenzte Signal über eine von dem ersten Widerstand (34) gebildete Ausgangsimpedanz zugeführt wird, jedoch dann, wenn die Amplitude des amplitudenbegrenzten Signals gleich oder größer ist als der von der Amplitudendetektoreinrichtung (E, 36, 38) detektierbare Wert, das amplitudenbegrenzte Signal als ein mit Hilfe des ersten und des zweiten Widerstands (34, 35) geteiltes Signal zugeführt wird.

5. Nichtlineare Deemphasisschaltung (20) nach einem der vorhergehenden Ansprüche, bei der der von Null verschiedene Wert des Verstärkungsfaktors gleich Eins ist.

## Revendications

1. Circuit de désaccentuation non linéaire (20) comprenant :
un premier circuit de soustraction (13) pour soustraire, d'un signal d'entrée (S_{RF}), un signal limité en amplitude ;
un circuit de filtre passe-haut (7) pour extraire des composantes à haute fréquence du signal de sortie dudit premier circuit de soustraction (13) ;
un premier circuit limiteur (8) pour limiter en amplitude le signal de sortie dudit circuit de filtre passe-haut (7), lorsqu'une valeur d'entrée du premier circuit limiteur (8) excède une valeur de limitation d'amplitude (LIM1), pour produire ainsi ledit signal limité en amplitude pour le délivrer audit premier circuit de soustraction (13) ;
un circuit d'amplification non linéaire (12, 22 ; 30) pour amplifier, lorsque le signal limité en amplitude a une amplitude à l'intérieur d'une plage de valeurs de faible amplitude (a₁) qui est fixée pour être inférieure à la valeur de limitation d'amplitude (LIM1) dudit premier circuit limiteur (8), le signal limité en amplitude avec un gain non nul (G = y) plus grand qu'une valeur prédéterminée ; et
un second circuit de soustraction (16) pour soustraire le signal de sortie dudit circuit d'amplification non linéaire (12, 22 ; 30) du signal d'entrée (S_{RF}) pour produire un signal de sortie (S_{RF2}) dudit circuit de désaccentuation non linéaire (20) ;
ledit circuit d'amplification non linéaire (12, 22 ; 30) servant en outre, en réponse à une augmentation d'amplitude du signal limité en amplitude au-delà de ladite plage de valeurs de faible amplitude (a₁), à modifier la caractéristique d'entrée/sortie pour que ledit circuit d'amplification non linéaire (12, 22 ; 30) amplifie le signal limité en amplitude avec un gain égal à ladite valeur non nulle prédéterminée.

2. Circuit de désaccentuation non linéaire (20) selon la revendication 1, dans lequel ledit circuit d'amplification non linéaire comprend : un second circuit limiteur (12) auquel on applique le signal limité en amplitude, le second circuit limiteur (12) ayant une valeur de limitation d'amplitude (LIM2) qui est la valeur d'entrée du second circuit limiteur (12) au-dessus de laquelle il ne se produit pas de changement de la valeur de sortie, la valeur de limitation d'amplitude (LIM2) du second circuit limiteur (12) étant inférieure à la valeur de limitation d'amplitude (LIM1) dudit premier circuit limiteur (8) ; et un mélangeur (22) pour mélanger le signal de sortie dudit second circuit limiteur (12) avec le signal limité en amplitude issu du premier circuit limiteur (8), ledit circuit d'amplification non linéaire ayant une caractéristique d'amplification d'entrée/sortie non linéaire qui dépend du rapport de mélange dudit mélangeur (22).

3. Circuit de désaccentuation non linéaire selon la revendication 2, dans lequel le mélangeur est un mélangeur variable (22).

4. Circuit de désaccentuation non linéaire selon la revendication 1, dans lequel ledit circuit d'amplification non linéaire (30) comprend : un amplificateur (32) auquel le signal limité en amplitude est délivré ; une première résistance (34) connectée à un côté sortie dudit amplificateur (32) ; une seconde résistance (35) connectée à un côté sortie de ladite première résistance (34) ; et un moyen de détection d'amplitude (E, 36, 38) connecté à ladite seconde résistance (35) ; et dans lequel le signal limité en amplitude est délivré, par l'intermédiaire d'une impédance de sortie fournie par ladite première résistance (34), lorsque l'amplitude du signal limité en amplitude est inférieure à une valeur pouvant être détectée dudit moyen de détection d'amplitude (E, 36, 38) mais, lorsque l'amplitude du signal limité en amplitude est égale ou supérieure à la valeur pouvant être détectée dudit moyen de détection d'amplitude (E, 36, 38), le signal limité en amplitude est délivré sous forme d'un signal divisé par lesdites première et seconde résistances (34, 35).

5. Circuit de désaccentuation non linéaire (20) selon l'une quelconque des revendications précédentes, dans lequel la valeur non nulle prédéterminée de gain est l'unité.
